Europäisches Patentamt

European Patent Office

Office européen des brevets

(19)

(11) **EP 1 501 191 A1**

(12) **EUROPEAN PATENT APPLICATION**

(43) Date of publication:
26.01.2005 Bulletin 2005/04

(51) Int Cl.⁷: **H03H 21/00**, H04B 3/23,
H04L 27/26

(21) Application number: 03016993.2

(22) Date of filing: 25.07.2003

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: STMicroelectronics S.r.l.
20041 Agrate Brianza (Milano) (IT)

(72) Inventor: Bonaventura, Marco
30174 Venezia (IT)

(74) Representative: Bosotti, Luciano et al
c/o Buzzi, Notaro & Antonielli d'Oulx Srl,
Via Maria Vittoria, 18
10123 Torino (IT)

(54) **Method for echo cancellation in a DMT modem apparatus, DMT modem apparatus and computer program product thereof**

(57)     A method for cancelling the Echo part of a received DMT signal in presence of Far-End signal in a ADSL modem, in particular Central Office modem, where an adaptive filtration of the received signal is performed by means of a FIR filter having multiple taps for implementing a full Least Mean Square error procedure, said Least Mean Square procedure comprising the step of estimating the impulse response ($w(k)$) of said FIR filter evaluating an update ($w(k+1)$) of the estimation in function of a correction increment parameter ($\mu_k$).

The method provides for performing a per-tone compensation step that comprises evaluation of a per-tone increment correction ($\mu_k$) that depends on the mask of tones used.

Further, the method provides for performing a low taps compensation step reducing the number of modes to be compensated in the update to a subset ($N_{LM}$) limited to the lower modes, in particular to the lower two, in order to have a high efficiency in terms of computational complexity.

FIG. 7

EP 1 501 191 A1

# EP 1 501 191 A1

**Description**

The present invention relates to techniques for Least Mean Square (LMS) Echo Cancellation (EC) in a DMT (Discrete Multitone Technique) modem, in particular a ADSL Central Office (CO) modem.

In the following reference will be made to several widely known methods and circuits for telecommunications. Reference is made to publications such as N. Benvenuto and G. Cherubini 'Algoritmi e Circuiti per le Telecomunicazioni', Libreria Progetto, Padova Italy, S. Haykin, "Adaptive Filter Theory", Prentice Hall, New Jersey, 1986, B. Widrow, "Adaptive filters", in aspects of Network and System Theory, ed. Kalman, New York, 1970, G. Cariolaro, "Analisi spettrale", Libreria Progetto, Padova, Italy, 1995, G. Cariolaro, "La Teoria unificata dei segnali", UTET, 2001.

The new generation of ADSL modem requires a high performance adaptive echo-cancellation method, that shows improved convergence properties.

Known echo cancellations methods for cancelling the echo part of a received signal in presence of far-end signal, like the methods described in *"Discrete Multitone Echo Cancellation"* Minnie Ho, Cioffi, IEEE Transactions on Communications Vol. 44 NO. 7 July 1996, show performance drawbacks that make them not usable in a real ADSL application.

The common approach provides for modeling the acoustical echo path using an adaptive linear combiner, which is a digital filter with adjustable coefficients. The coefficient update is performed via some adaptation method.

Recursive Least Squares (RLS) based methods have a too high computational complexity and are not reliable, whereas other time domain Least Mean Squares methods show poor results, i.e. poor convergence vs. tracking properties or no compliancy with ITU G.992.1 standard. Finally, methods based on frequency domain decision feedback with LMS error minimisation, that, to decrease the computation complexity, simplify the update equation, show a degradation of convergence because of the loss of information due to such a simplification.

On the other hand "Full LMS" methods, that are efficient computational complexity LMS methods with frequency domain decision feedback, i.e. with no update simplification, are considered to show the best performance among EC LMS based methods. It is known a simplified version of such method called "Leven", providing for reducing the computational complexity, that does not suffer of some performance degradation like other methods. The main drawback of such "Leven" method, however, is the increase of the peak excess noise that can be tolerated reducing the correction coefficient.

It is also known that the introduction of a per-tone correction can improve the convergence performance but it can sometimes create instability.

Both "Full LMS" and "Leven" methods can be considered optimum from a point of view of LMS error functional.

This is true for a reference stationary white signal.

However, the ADSL downstream DMT signal is:

- a coloured signal. This because only some tones are used in downstream transmission;
- a cyclostationary signal. This is due to the symbol based nature of DMT signal and the presence of Cyclic Prefix CP inserted for addressing channel distortion.

Said two features make both "Full LMS" and "Leven" sub-optimum when applied to ADSL DMT signal.

In fact, in a non-white condition the eigenvalue spread of the received signal correlation matrix is increased and so a reduced convergence speed can be observed.

Further, it is quite apparent that one of the basic properties of all the adaptive theory do not hold: a DMT signal is not a stationary signal. This is mainly due to the symbol based nature of such type of modulation. For example, if only a reduced number of tones is used, then all the samples of a certain symbol are strongly correlated while no correlation occurs with samples of other symbols. It is apparent therefore that increasing the number of tones used then the correlation between different samples of the same symbol decrease reducing the level of non-stationarity of the transmitted signal.

Also the insertion of the Cyclic Prefix CP, that is a partial symbol repetition, increase the level of cyclostationarity.

A phenomenon called "low taps problem" related both to "Full LMS" and "Leven" methods was recently observed, having the following features:

a. Depending on alignment, the model limitation will be reached very fast or very slow.
b. On some alignments, the model limitation will never be reached.
c. Depending on which among the 32 taps of the impulse response is "hit", this can have serious influence on convergence.

In the following, the result of some simulations is described in order to clarify the impact of "low taps problem" into the speed of convergence on a full LMS echo cancellation method.

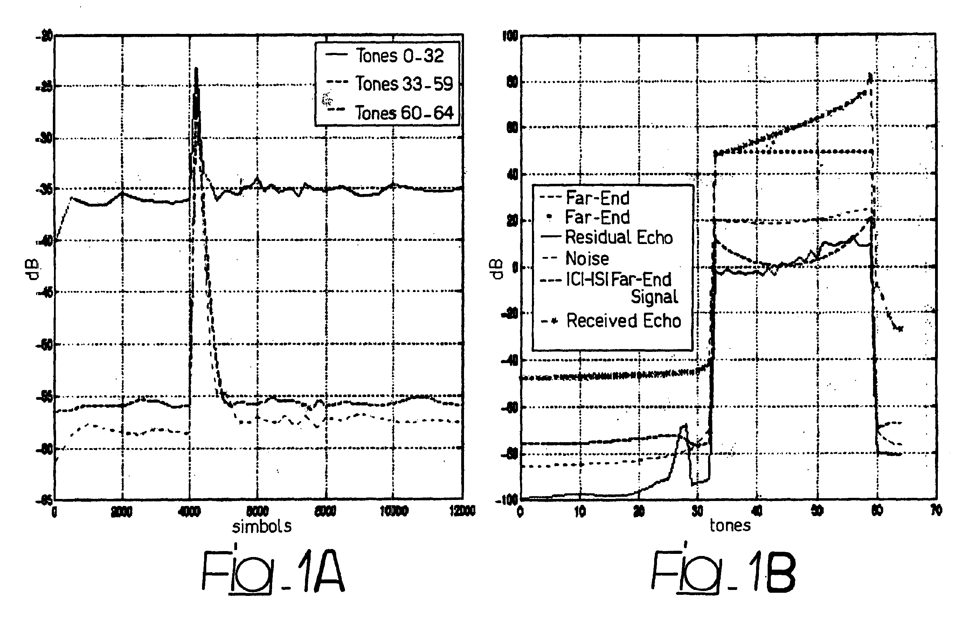

Figures 1A and 1B show the per-tone increment correction with misalignment 0@552kHz. The misalignment is the difference (in samples) between the transmitted and received DMT signal window. It has to be considered positive if the reference transmitted signal window is transmitted before the window of the received signal.

In Fig. 1A it is shown the power of residual echo derived into a demapper, i.e. the decoding device, of an ADSL modem, in some group of tones vs. the number symbols. It is possible to observe that at symbol 4000 there is the step variation of the echo path. The convergence is obtained in 1000 symbols.

In Fig. 1B it is shown the per-tone mean power of signal and noises over the last 500 of symbols (11500-12000), i.e. the per-tone mean power of far-end signal, received echo, residual echo, distortion and other noises into the demapper.

In this condition the performances are:

- CDC (Circulant Decomposition Canceller) without echo: 388kb/s
- CDC with echo: 388kb/s

This means a loss of performance of 0%.

In figures 2A and 2B are shown the results in case of a misalignment, in particular in the case of Misalignment = 66@552MHz.

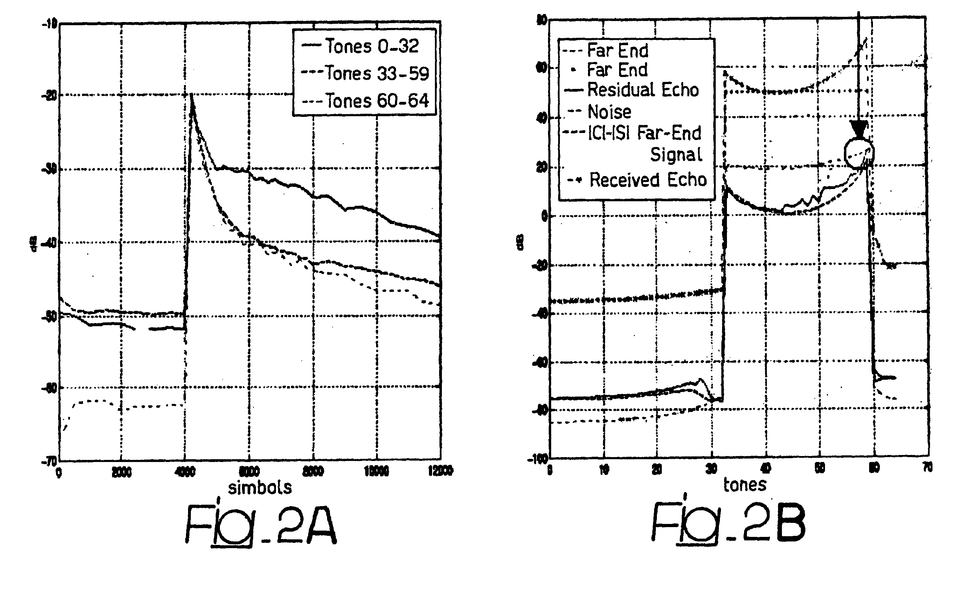

In Fig. 2A it is shown the power of residual echo derived into the demapper in some group of tone vs. the number symbols. At symbol 4000 there is the step variation of the echo path. The convergence is not obtained in 8000 symbols. All the groups of tones are involved in this low-convergence.

In Fig. 2B it is shown the per-tone mean power of signal and noises over the last 500 of symbols (11500-12000). The convergence was not obtained into tone 59, indicated with a circle, and the neighboring tones.

In this condition the performances are:

- CDC without echo: 388kb/s
- CDC with echo: 376kb/s This means a loss of performance of -3%.

Due to the fact that the convergence is an exponential decreasing function the speed of convergence decrease in function of the time. This problem is a severe drawback for the whole Echo Canceller approach.

Implementation in Central Office modems accounts for the most critical situation in ADSL environment, because the downstream signal is a short bandwidth reference signal and so all estimation problems become relevant.

The object of the present invention is thus to overcome the drawbacks of the prior art arrangements considered in the foregoing while providing an improved solution for echo cancellation in a DMT modem.

According to the invention such an object is achieved by means of a method having the features set forth in the annexed claims, which form an integral part of the description herein. The invention also relates to a corresponding modem apparatus and a corresponding computer program product directly loadable in the memory of a digital computer and comprising software code portions for performing the method of the invention when the product is run on a computer.

Substantially, a method for cancelling the echo part of a received signal comprising a full per-tone compensation method and a low modes compensation method, that is a simplification of the previous one, are proposed, the proposed methods involving decoupling of the non-white reference signal from cyclostationary reference signal problems. To solve the first problem it is proposed a solution that is dependent only on the tone mask used and to solve the second one it is proposed an efficient align-dependent error compensation.

Further objects, features and advantages of the present invention will become apparent from the following detailed description and annexed drawings, which are provided by way of non limiting example, wherein:

- figure 1A, 1B, 2A and 2B already referred in the foregoing show simulation diagrams of an echo cancellation method according to the prior art;

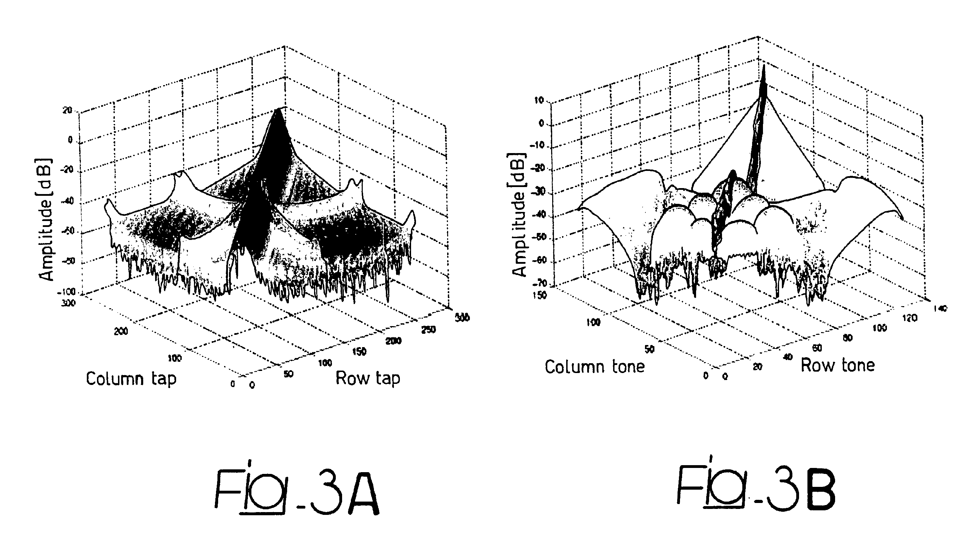

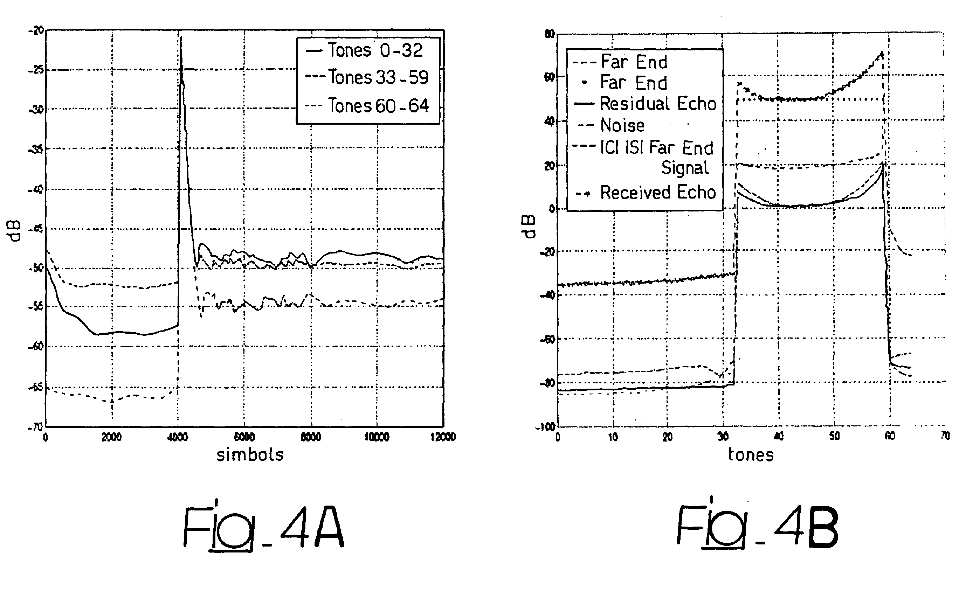

- figures 3A, 3B, 4A and 4B show the results of a simulation of the method according to the invention;

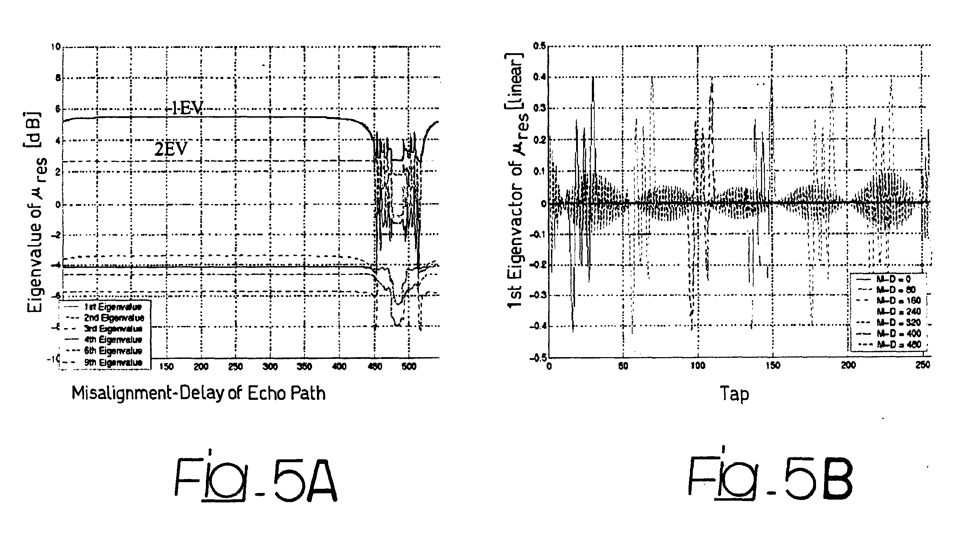

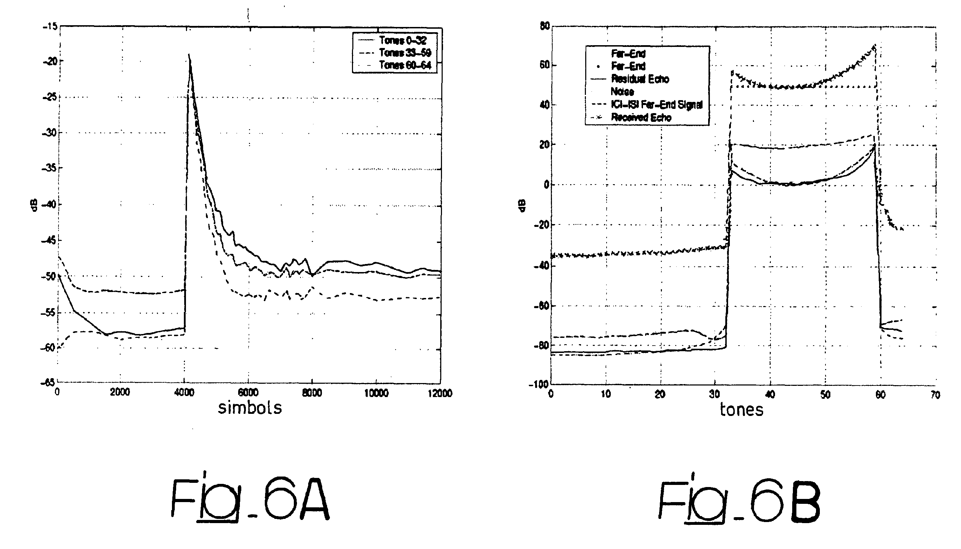

- figures 5A, 5B, 6A and 6B show the results of a simulation of a simplified embodiment of the method according to the invention;

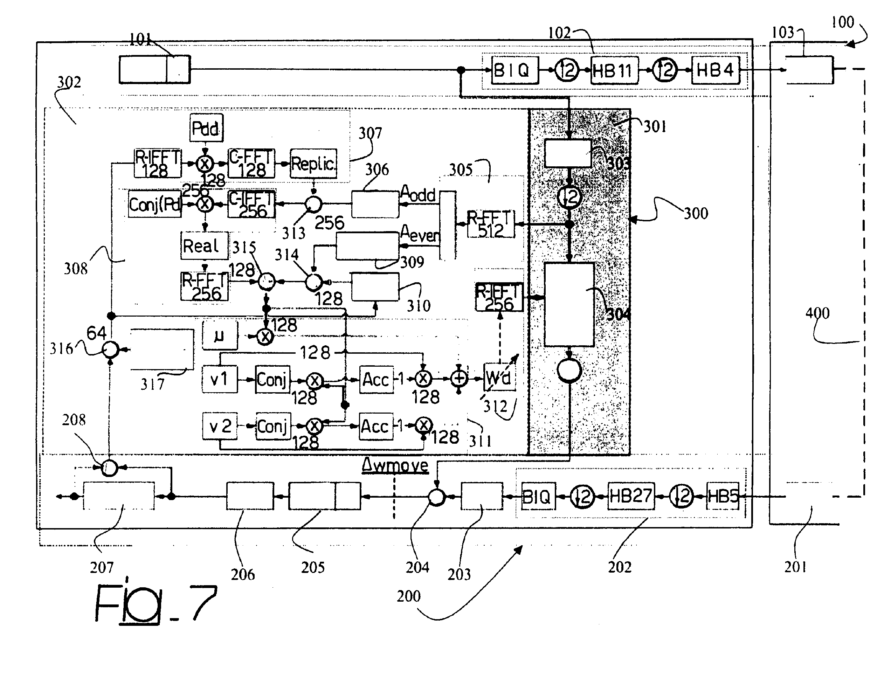

- figure 7 shows a block diagram of a modem apparatus implementing the simplified embodiment of the method according to the invention;

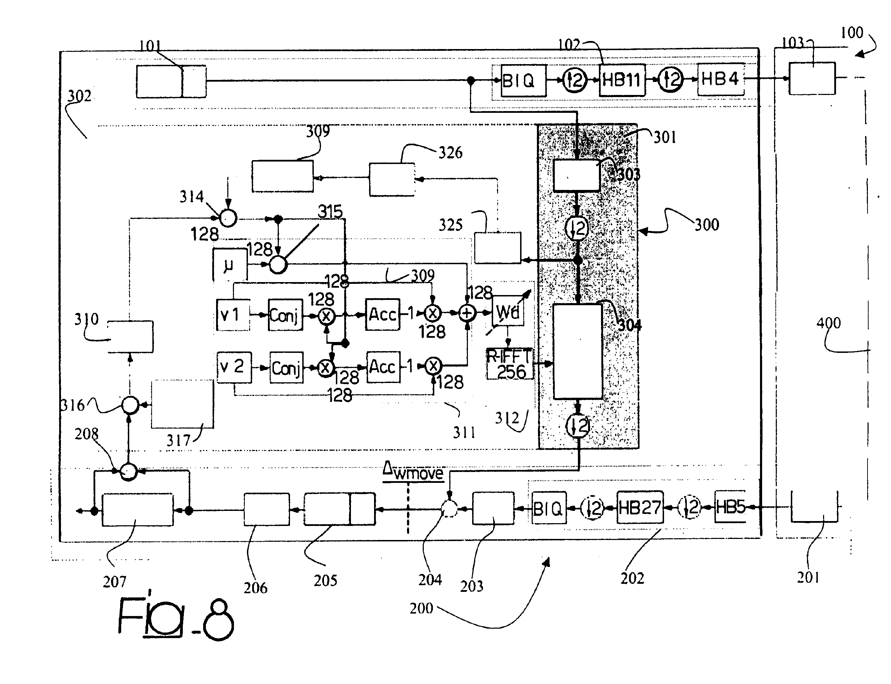

- figure 8 shows a block diagram of a modem apparatus implementing a variant to the simplified embodiment of the method according to the invention.

It was observed that the low taps problem phenomenon can be explained with the observation that the DMT signal is a non-white cyclostationary signal. As mentioned above, it was observed that is align-dependent and this is due to the cyclostationary nature of the signal. In other words the reference signal, depending on the alignment, does not excite the same taps of the echo cancellation impulse response.

It was also observed that for an extended number of downstream tones (full overlap case) said low taps problem phenomenon cannot be measured. This is in line with the previous consideration about the signal being ciclostationary. This also means that the worst case condition is related to a reduced number of tones (i.e. ITU G.992.1 Annex B AFDD).

Also the fact that the number of the "low taps" is equal to the number of cyclic prefix samples indicates a relation.

Said phenomenon is always present in the same taps of the echo cancellation impulse response and the impact on the performance is not the same depending on the energy of the impulse response under the window with the "low taps problem".

Since the "low taps problem" is related to the nature of the reference DMT signal and the statistical properties can a priori be known, the basic concept underlying the presently preferred embodiment of the invention is to exploit this knowledge together with the alignment to compensate in part or at all the eigenvalue spread, especially into low taps.

Also it is proposed to decouple the two different problem with two different solution:

- a real per-tone compensation that is dependent only on the mask of tones used. This compensation has to be performed into frequency domain to be computationally efficient. This is independent on the alignment;
- a "low taps compensation" that is a compensation of some dangerous modes. It is required that the number of modes to be compensated has to be reduced, in particular to two, in order to have a high efficiency in terms of computational complexity. Said low taps compensation is proposed to be performed into frequency domain, but it can be easily derived that it can be equivalently done into the time domain. Said low taps compensation is align-dependent. The compensation vector can be obtained with a circulant shift of an original vector, so that it is not needed to access to a compensation vector for each align.

The proposed method is particularly suitable for implementation in the Central Office modem side, because at CPE (Customer Premises's Equipment) side the per-tone compensation is enough to have good performances for different alignment.

In the following a echo cancellation method that involves full compensation is described.

In the proposed full LMS method with $T=T(k)$ is indicated the state vector matrix of the echo canceller filter, where w(k) indicates an estimated impulse response of a FIR echo path filter in the step (symbol) k, $\mu$ indicates the increment correction term and $e=e(k)$ the error of updating.

The update $w(k+1)$ of the FIR filter can be written as:

$$w(k+1) = w(k) + \mu \cdot T^H \cdot e \qquad \text{Eq. 1}$$

Usually the increment corrrection term $\mu$ is considered a scalar correction. It can be considered, in frequency update environment, a per-tone correction.

In the proposed method it is provided to derive the energy introduced in the calculation per tone that means to derive the mean power (in each row) of

$$FT(k) = F \cdot T^H \qquad \text{Eq. 2}$$

where F is a Discrete Fourier Transform matrix, and to fix the per-tone correction $\mu$ to the inverse of such quantity. The basic idea is to derive the statistical power of each tone vector and to compensate it. In other words it is proposed to extract an increment correction $\mu_k$ for each tone k:

$$\mu_k = \frac{\mu_0}{E\left\{\left\|FT_{k,j}^2\right\| \cdot 1_{Nx1}\right\}} \qquad \text{Eq. 3}$$

where N indicates the dimension of the state vector matrix T.

In the proposed method it is considered like a square matrix correction.

In the following a stability and performance analysis of the full compensation LMS method based on the mean squared value of the estimation error $e(k)$ is presented.

The weight-error vector is defined like difference of the estimated impulse response of the FIR filter w(k) and $w_0$ the optimum Wiener solution for the tap-weight vector at iteration k.

$$\varepsilon(k) = w(k) - w_0 \qquad \text{Eq. 4}$$

Defined h the impulse response of the echo-channel it is also defined $d=T \cdot h$, then the output of estimated can be written

$$e(k) = d(k) - T(k) \cdot w(k) \qquad \text{Eq. 5}$$

Using equation 1 into eq. 4 and finally substituting eq. 5 it can be obtained the weight error vector expression:

$$\varepsilon(k+1)=[I-\mu T^H \cdot T]\varepsilon(k)+\mu \cdot T^H \cdot e_0(k) \qquad \text{Eq. 6}$$

where $e_0(k)$ in the estimation error produced in the optimum Wiener solution

$$e_0(k)=d(k)-T \cdot w_0 \qquad \text{Eq. 7}$$

Now, the direct averaging method used in the proposed echo cancellation method is described.

Equation 6 is a stochastic difference equation in the weight-error vector $\varepsilon(k)$. To study the convergence behavior of such stochastic algorithm in an average sense, it is possible to invoke a direct-averaging method, known from H.J. Kushner, *"Approximation and Weak Convergence Methods for Random Processes with application to Stochastic System Theory"*, MIT Press, Cambridge Mass.,1984. According to this method equation 6, for a small step size parameter $\mu$, is close to the solution of another stochastic difference equation whose system matrix is equal to the ensemble average:

$$E[I-\mu \cdot T^H \cdot T]=I-\mu \cdot R_T \qquad \text{Eq. 8}$$

where $R_T$ is the correlation matrix of the state matrix of the filter T. More specifically eq. 6 can be replaced with

$$\varepsilon(k + 1) = [I - \mu \cdot R_T)\varepsilon(k) +\mu \cdot T^H \cdot e_0(k) \qquad \text{Eq. 9}$$

The correlation matrix $R_T$ is always nonnegative definite. Also the correlation matrix $R_T$ is definite positive except for noise-free signal-processing problems.

Now, the stability of the Least Mean Square procedure is discussed.

To determine the condition for the stability of the proposed LMS update, a method which is similar to the steepest-descent algorithm stability approach is used. The natural modes of the method are examined.

To study the stability of this method the feedback loop term of equation 9 can be considered

$$\varepsilon(k + 1) = [I -\mu \cdot R_T ]\varepsilon(k) \qquad \text{Eq. 10}$$

Using the unitary similarity transformation, the correlation matrix can be expressed as follow

$$R_T =Q \cdot \Lambda \cdot Q^H \qquad \text{Eq. 11}$$

The matrix Q has as its columns an orthogonal set of eigenvector associated with the eigenvalue of the matrix

$R_T$.

Also Q is an unitary matrix ( $Q^H \cdot Q = I \Rightarrow Q^{-q} = Q^H$) and is a diagonal matrix whose elements are the eigenvalues of the matrix $R_T$.

Substituting eq. 11 into eq. 10 it is obtained

$$\varepsilon(k+1) = [I - \mu - Q \cdot \Lambda \cdot Q^H]\varepsilon(k) \qquad \text{Eq. 12}$$

Defining a new set of coordinates ④ as follow

$$v(k) = Q^H \cdot \varepsilon(k) \qquad \text{Eq. 13}$$

and premultiplying both sides of equation 12 it is obtained

$$v(k + 1) = [I - \mu_Q \cdot \Lambda]v(k) \qquad \text{Eq 14}$$

where

$$\mu_Q = Q^H \cdot \mu \cdot Q \qquad \text{Eq .15}$$

The matrix $\mu_Q$ can be seen like a diagonal matrix with element $\mu_{Q,n}$. Indeed it is enough to compensate all the modes.

From eq. 14 the nth natural mode of the method can be written as

$$v_n(k+1) = (1 - \mu_{Q,n} \cdot \lambda_n)v_n(k), \; n=0,...,N-1 \qquad \text{Eq. 16}$$

Eq. 16 is a geometric series. For stability the magnitude of the geometric ratio must be less then 1.

For all the real and positive eigenvalue a necessary and sufficient condition for the convergence or the stability is

$$0 < \mu_{Q.n} < \frac{2}{\lambda_n} \qquad \text{Eq. 17}$$

The n-th time constant can be expressed in terms of the step size parameter and eigenvalue

$$\tau_n = -\frac{1}{1n(1 - \mu_{Q,n} \cdot \lambda_n)} \qquad \text{Eq. 18}$$

Applying the same speed of convergence (same time constant) to all the modes it is obtained

$$\mu_Q = \mu_0 \cdot \Lambda^{-1} \qquad \text{Eq. 19}$$

and using eq. 15 and 19 it is finally obtained for the increment correction matrix $\mu$

$$\mu = \mu_0 \cdot Q \cdot \Lambda^{-1} \cdot Q^H \qquad \text{Eq. 20}$$

where $0 < \mu_0 < 2$. If some null eigenvalues are present they are not considered into the eq. 20 inversion.

It is clear that all this operations are possible with the knowledge of the correlation matrix $R_T$.

Therefore it is shown in the following the method of derivation of the correlation matrix for a DMT signal.

The major problem of a DMT signal is that it is not a stationary signal.

The correlation of a signal x the function is

$$r_x(\tau, t) = E[x(t) - x^*(t - \tau)] \qquad \text{Eq. 21}$$

with t $\in$ Z (T) since it is considered on a digital signal transmitter.

A DMT signal is a cyclostationary signal. This means

$$r_x(\tau,t) = r_x(\tau, t+T_c) \qquad \text{Eq. 22}$$

where Tc is the period of one DMT symbol. In Eq.22 the presence of the cyclic prefix is not kept into account. It can be observed that the period of the DMT symbol can be related to the number of tones of the inverse fast fourier transform IFFT ($N_T/2$) and the length of cyclic prefix ($v$) : $T_c = T (v + N_T)$.

Into the following considerations will be done the hypothesis of uncorrelation between samples of different symbols.

The DMT Signal Just after demodulator s(t) is expressed as

$$s(t) = \frac{1}{N_T} \sum_{m=-\infty}^{+\infty} \sum_{k=0}^{N_T-1} a_m^k \sum_{n=-v}^{N_T-1} e^{j2\pi kn/N_T} \delta(t - nT - m(N_T + v)T) \qquad \text{Eq.23}$$

Without loss of generality it is imposed T=1. Due to correlation periodic property it can be derived $r_x(\mathbf{0},t)$ for $-v < t < N_T$.

This means that it is possible to refer to only one symbol (m=0 for example). Imposing $\alpha_m^k = (\alpha_m^{NT-k})^*$ also, with k=0,...,$N_T/2-1$, eq. 23 yields a real baseband signal.

From eq. 23 it is obtained

$$s(t) = \frac{1}{N_T} \sum_{k=0}^{N_T-1} a_m^k \cdot e^{j2\pi kt/N_T} \text{ for } -v \leq t < N_T, m=0 \qquad \text{Eq. 24}$$

This equation is rewritten keeping into account the symmetry ( hermitian ) of the information per-tone.

Into the hypothesis that no information will be inserted into DC and Nyquist tones it is obtained

$$s(t) = \frac{1}{N_T} \sum_{k=0}^{N_T/2-1} a_k \cdot e^{j2\pi kt/N_T} + a_{N_T-k} \cdot e^{j2\pi(N_T-k)t/N_T} = \frac{1}{N_T} \sum_{k=0}^{N_T/2-1} a_k \cdot e^{j2\pi kt/N_T} + a_k^* \cdot e^{-j2\pi kt/N_T} \qquad \text{Eq. 25}$$

Eq. 25 can be rewritten in function of only sine and cosine.

$$s(t) = \frac{2}{N_T} \sum_{k=0}^{N_T/2-1} \text{Re}[a_k] \cdot \cos(2\pi kt/N_T) - \text{Im}[a_k] \cdot \sin(2\pi kt/N_T) \qquad \text{Eq. 26}$$

Defined

$$G(t) = \{g_k(t)\}_{k=0,\ldots,N_T-1} \text{ and } g_k(t) = \cos(2\pi kt / N_T)$$
$$F(t) = \{f_k(t)\}_{k=0,\ldots,N_T-1} \text{ and } f_k(t) = \sin(2\pi kt / N_T) \qquad \text{Eqs. 27}$$
$$A_m = \{a_m^k\}_{k=0,\ldots,N_T-1}$$

all the previous vectors have to be considered column vectors.

Substituting eqs. 27 which introduce a vector notation into eq. 26 it is derived the DMT Signal Just after demodulator s(t)

$$s(t) = \frac{2}{N_T}\left(G(t)^T \cdot \operatorname{Re}[A_0] - F(t)^T \cdot \operatorname{Im}[A_0]\right) \qquad \text{Eq. 28}$$

Now, the method for deriving the Correlation function Just after modulator is described

The correlation of a DMT signal is derived under the hypothesis

- uncorrelation of samples of different symbols;
- uncorrelation between real and imaginary information per-tone $E\{Re[a_k]\cdot Im[a_k]\} = 0$ ;
- uncorrelation between information on different tones;
- the statistical power for real and imaginary part is the same for each tone. This means that each real/imaginary power with the second hypothesis. is the half of the statistical power of each complex signal per-tone.

From the previous hypothesis it can be concluded that:

- the correlation can be defined between -④ [t<$N_T$ due to its periodic property. It is possible to refer for the moment to a correlation function not null only in this period;
- the correlation (into one period) into the hypothesis of uncorrelation between information of different symbols is

$$r_x(\tau,t) = \begin{cases} 0 & \textit{otherwise} \\ \neq 0 & -v \leq t - \tau < N_T \quad \textit{and} \quad -v \leq t < N \end{cases}$$

The correct correlation of the signal can be finally written as

$$r_{xp}(\tau,t) = \sum_{m=-\infty}^{+\infty} r_x(\tau, t - mT_C)$$

which keeps into account the periodicity of the signal.

It is proposed to derive the not null part of the correlation.

$$s(t) = \frac{2}{N_T}\sum_{k=0}^{N_T/2-1} \operatorname{Re}[a_k]\cdot\cos(2\pi kt / N_T) - \operatorname{Im}[a_k]\cdot\sin(2\pi kt / N_T)$$

From eq. 28, under the hypothesis of uncorrelation between real and imaginary information per-tone the cross multiplication can be considered null.

$$E[s(t)\cdot s(t-\tau)] = \frac{2}{N_\gamma}E\{G^T(t)\cdot\operatorname{Re}[A_m]\cdot\operatorname{Re}[A_m]^H\cdot G^*(t-\tau) + F^T(t)\cdot Im[A_m]\cdot Im[A_m]^H\cdot F^*(t-\tau)] \qquad \text{Eq. 29}$$

From eq. 29 using hypothesis of uncorrelation between information on different tones the central multiplication can be considered a diagonal matrix. Defined

$$E[\text{Re}[a_k] \cdot \text{Re}[a_k]^*] = \sigma^2_{k,j}.$$ Eq. 30

$$E[\text{Im}[a_k] \cdot \text{Im}[a_k]^*] = \sigma^2_{k,i}$$

From eq. 29 and 30 it is obtained

$$E[s(t) \cdot s(t-\tau)] = \frac{4}{N_\gamma^2}\{G^T(t)\cdot diag[\{\sigma^2_{k,r}\}]\cdot G^*(t-\tau) + F^T(t)\cdot diag[\{\sigma^2_{k,t}\}]\cdot F^*(t-\tau)\}$$ Eq. 31

or

$$E[s(t) \cdot s(t-\tau)] = \frac{4}{N^2}\sum_{\hat{}}^{N_T/2-1}\sigma^2_{k,r} \cdot \cos(2\pi kt/N_T)\cdot\cos(2\pi k(t-\tau)/N_T) + \sigma^2_{k,i} \cdot$$

$$\cdot \sin(2\pi kt/N_T)\cdot\sin(2\pi k(t-\tau)/N_T)$$ Eq. 32

Under the fourth hypothesis, that the statistical power for real and imaginary part is the same for each tone, it is easily obtained

$$r_x(\tau,t) = E[s(t) \cdot s(t-\tau)] = \frac{2}{N_T^2}\sum_{k=0}^{N_T/2-1}\sigma^2_k \cdot \cos(2\pi k\tau/N_T)$$ Eq. 33

where with $\sigma_k$ is indicated the per-tone power.

It can be observed that into its domain of validity, that is function of both t and $\mathbf{0}$, it is related only to $\mathbf{0}$. For this reason into the next considerations it will be referred to $r_x(\mathbf{0}) = r_x(\mathbf{0}, t)$ for $-v < t - \mathbf{0} < N_T$ and $-v < t < N_T$.

The cyclostationarity is due to the validity of eq. 32 and 33, i.e. the correlation is null outside the symbol.

An efficient derivation procedure of eq. 33 will be shown in a further part of the description.

In the following the derivation of the correlation function of a filtered DMT signal in the proposed method will be described.

A DMT signal filtered by a time-invariant FIR with impulse response *h* is considered.

The output of the filter is ciclostationary if the input is ciclostationary.

The correlation is derived into time to time function because is more efficient of a Spectral Density passage.

The output y (domain U) of a filter h() with input signal x (domain I) is (generalized Haar integration)

$$y(t) = \int_I du \cdot h(t-u) \cdot x(u)$$ Eq. 34

Defined

$$s_y(t1, t2) = E[y(t1) \cdot y^*(t2)]$$ Eq. 35

$$s_x(t1,t2) = E[x(t1) \cdot x^*(t2)]$$

it is obtained

$$s_y(t1,t2) = \int_1 du1 \int_1 du2 \cdot h(t1 - u1) \cdot s_x(u1, u2) \cdot h^*(t2-u2) \qquad \text{Eq. 36}$$

It is more interesting to rewrite eq. 36 using eq. 21 definition

$$r_y(\tau, t) = s_y(t, t-\tau) = \int_1 du2 \cdot h^*(t - \tau - u2) \int_1 du1 \cdot h(t - u1) \cdot r_x(u1-u2,u1) \qquad \text{Eq. 37}$$

Introducing now the hypothesis of cyclostationarity of input signal (domain $\in Z(T)/Z(T_c)$) the previous relation can be written

$$r_{yp}(\tau,t) = \int_1 du2 \cdot h^*(t-\tau-u2) \int_{1c} du1 \cdot h(t-u1) \cdot r_{xp}(u1-u2,u1) \qquad \text{Eq. 38}$$

Keeping into account that $I=Z(T)$ and $I_c=Z(T)/Z(T_c)$ it is possible to rewrite eq. 38 as

$$r_{yp}(\tau,t) = \sum_{u2=-\infty}^{+\infty} h^*(t-\tau-u2) \cdot \sum_{u1=-v}^{N_T-1} h(t-u1) \cdot r_{xp}(u1-u2,u1) \qquad \text{Eq. 39}$$

For a more efficient derivation of eq. 39 it is possible to refer to $r_x(\ ,\ )$.
It can be observed that

$$r_y(\tau,t) = \sum_{u2=-v}^{N_T-1} h^*(t-\tau-u2) \cdot \sum_{u1=-v}^{N_T-1} h(t-u1) \cdot r_x(u1-u2,u1) \qquad \text{Eq. 40}$$

And, to keep account the periodicity of the output,

$$r_{yp}(\tau,t) = \sum_{k=-\infty}^{+\infty} r_y(\tau,t-k \cdot T_C) \qquad \text{Eq. 41}$$

An efficient derivation of eq.40 is proposed further on in the description.
Now, for what concerns the derivation of state vector correlation matrix $R_T$, defined the square matrix T with dimension N the state vector matrix of EC FIR filter.

$$T = \begin{bmatrix} x_D & x_{D-1} & x_{D-2} & \cdots & & x_{D-N+1} \\ x_{D+1} & x_D & x_{D-1} & & & \\ x_{D+2} & x_{D+1} & x_D & \ddots & & \\ \vdots & & \ddots & \ddots & & x_{D-1} \\ x_{D+N-1} & & & x_{D+1} & & x_D \end{bmatrix}$$

and

$$R_T = E[T^H \cdot T] \qquad \text{Eq. 42}$$

it is easy, now, to derive $R_T$ correlation matrix

$$[R_T]_{i,j} = \sum_{k=0}^{N-1} r'_{yp}\left(|i-j|, k+D-\min(i,j)\right)$$

Eq. 43

It can be seen that correlation matrix $R_T$ is symmetric.

In figures 3A and 3B are shown the result of simulation of the full compensation method, using the update defined in eq. 1, where the increment correction matrix ③ is derived from eq. 20 and the correlation matrix $R_T$ is derived from eq. 43.

The complexity of this increment scaling is, in the proposed implementation due to the decimation before the FIR echo canceller, $256^2$ multiplication to be added to the standard update using Full-LMS complexity.

In Figures 3A and 3B a full compensation increment correction matrix for a misalignment of 66@552Mhz is shown. In figure 3A it is shown the power (amplitude) of the increment matrix per tap in time domain (taps 0-255). In figure 3B it is shown the power of the increment matrix per tone in frequency domain (tones 0-128)

In figures 4A and 4B the full compensation increment correction is shown. In figure 4A it is shown the power of residual echo derived into the demapper in different group of tones, 0 to 32, 33 to 59 and 60 to 64 in particular, in function of the number symbols. In figure 3B it is shown the per-tone mean power of far-end signal, received echo, residual echo, distortion and other noises into the demapper.

In this condition the performances are:

- CDC without echo: 388kb/s
- CDC with echo: 388kb/s

That means a loss of performance of 0%.

The performances of this method are really better then the performances of per-tone increment update version shown with reference to figure 2A and 2B. With the proposed method the convergence can be obtained in less then 600 of symbol instead of more then 8000 symbols (in 8000 symbols the convergence was not yet obtained, see fig. 2A, in other simulation to obtain the same level of residual echo are needed approximately 40000 symbols).

The proposed full LMS compensation method gives very good results but it is also very complex.

The increment correction matrix is alignment dependent and requires storing a lot of information. The alignment at Central Office modem cannot be known a priori, so ideally $256^2$ real number should be stored for each alignment. It was proved that 16 bit are just enough to obtain good performances behaviour. This is the major problem to be solved for its implementation.

As it can be seen in Fig. 3A the full compensation increment correction matrix $\mu$ can be seen like the sum of two components:

- the first one is due to the standard update, in which the compensation pushes the diagonal components, i.e. it is increased the tap to tap contribution. It is apparent that also the neighboring taps are correlated with this one so it is possible to understand that the compensation increment correction matrix $\mu$ decrease with the distance from the main diagonal
- the second component is the 'cross' over the full compensation increment correction matrix $\mu$. that can be noticed in fig. 3A. It is readily understandable that such a 'cross' pushes some taps over the impulse response and this explains the reason of the non-convergence in some taps without full compensation.

Also it can be easily observed that the position of the 'cross' is dependent on the alignment and the delay of Echo Path.

In the simulation the impact of low-mode problem is more complex, it depends also on the level of impulse response energy in the 'low taps'. It is clear that if in those taps there is no energy then no problem of convergence can be found and vice versa.

From the analytic study it is clear that low taps problem is due to cyclic prefix influence onto the correlation properties. Indeed this problem is related to the taps corresponding to the Cyclic Prefix taps.

Therefore in the following a low-complexity embodiment of the proposed method, for the 32-taps problem, it will be described. Said embodiment can be regarded as a simplification of the Full LMS Compensation method disclosed above.

The basic idea underlying said embodiment is to support the optimal per-tone correction and to add one or more correction terms to obtain the convergence.

The full compensation method can be rewritten like sum of each eigenvalue/vector contribution of the correlation matrix. Eq. 1 can be written using eq. 20

$$w(k+1) = w(k) + \mu_0 \cdot \sum_{n=0}^{N-1} \lambda_n^{-1} \cdot q_n \cdot q_n^{H} \cdot e_T \qquad \text{Eq. 44}$$

where $\lambda n$ is the eigenvalue of the correlation matrix and $q_n$ is its corresponding eigenvector associated to a certain natural mode.

Since from observation of figures 3A and 3B turns out that the per-tone optimal correction is able to push for a lot of natural modes but not some low modes, i.e. the modes that generate low-taps problem, it is intended to add some contribution able to push said low modes.

The frequency domain per-tone optimal increment matrix $\mu_{f,PT}$ can be defined as

$$\mu_{f,PT} = diag(\{\mu_k\}_{k=0,...,N-1}) \qquad \text{Eq. 45}$$

where the increment $\mu_k$ with k=0,...,N-1, is defined further on the in the description, in particular with reference to eq. 57. The low-mode compensation update can be written

$$w(k+1) = w(k) + \mu_0 \cdot F^{-1} \mu_{f,PT} \cdot F \cdot e_T + \mu_0 \cdot \sum_{n=0}^{N_{LM}-1} \alpha_n^{-1} \cdot p_n \cdot p_n^{H} \cdot e_T \qquad \text{Eq. 46}$$

where $\alpha_n$ is the eigenvalue of the correlation matrix and $p_n$ is its corresponding eigenvector that is associated to the low modes and $N_{Lm}$ is the number of Low Modes.

With this method it is reduced both the computation complexity and thememory needed to store the eigenvalue/vector.

Here the eigenvalues/vector of the residual matrix

$$\mu_{res} = \mu_{full} - F^{-1} \mu_{f,PT} \cdot F \qquad \text{Eq. 47}$$

are studied for different misalignments. In fig. 5A some eigenvalues of the residual matrix $\mu_{res}$ for different value of Misalignment-Delay of Echo Path are shown. In figure 5B the eigenvector corresponding to the first and biggest eigenvalue for different values of Misalignment-Delay of Echo Path (into @2.2MHz) is shown.

As it can be seen in Fig 5A, there is a clear difference between the first 2 eigenvalues, indicated with 1EV and 2EV, an all the others. The first eigenvalue is usually related to the low taps problem but the second eigenvalue is related to another phenomenon, which do not permit the normal convergence in the marginal taps (first and last 20 taps). The inconvenient due to such second phenomenon can be dealt with the same approach.

Also the third eigenvalue/vector is related to the original low-taps problem but the eigenvalue is really smaller.

It can be also observed that this problem relevant only with a misalignment between -26 and +449 @2.2MHz (TBC). In this region the value of the corresponding first eigenvalue is very flat.

Also it can be observed from fig. 5B that in this region, the first eigenvector is approximately obtained with a circulant shift.

That is not true between +450 and +519.

In figures 6A and 6B are shown the results of simulation of the low taps compensation method obtained using eq. 1 update, where the increment correction matrix is derived from eq. 20 and the correlation matrix is derived from eq. 43.

The complexity of this increment scaling is, in our implementation due to the decimation before the FIR echo canceller, $256^2$ multiplication to be added the standard update (Full-LMS) complexity. It can be observed that the additional complexity is more than double than the complexity of the base-update.

In fig. 6A it is shown for the Low mode compensation correction with a misalignment of 66@552kHz, the power of residual echo derived into the demapper in some group of tone vs the number symbols.

In figure 6B it is shown the Low mode compensation correction with a misalignment of 66@552kHz, the per-tone mean power of far-end signal, received echo, residual echo, distortion and other noises into the demapper.

In this condition the performances are:

- CDC without echo: 388kb/s;
- CDC with echo: 388kb/s

That means a loss of performance of 0%.
The performances are a little worse than the full compensation case. This is due to:

- the frequency per tone compensation is not the same (we have used the mean case);
- the fact that not all the low taps modes are pushed.

However performances are better than those of known methods, i.e. the method shown with reference to fig. 2. The convergence can be considered obtained after 2000 symbols.
In the following efficient derivation methods for the above equations are described
An efficient proposed derivation of eq. 33 is based on the only hypothesis that all used tones have the same power level $\sigma_k^2 = \sigma^2$ for D1 < k < D2 with D2<$N_T$. In this case eq. 33 can be written

$$r_x(\tau) = \frac{\sigma^2}{N_T^2} \sum_{k=D1}^{D2} \left( e^{j2\pi k\tau/N_T} + cc \right) \qquad \text{Eq.48}$$

where cc indicates complex conjugate. Collecting an exponential term and solving the exponential finite series it is obtained

$$r_x(\tau) = \frac{2 \cdot \sigma^2}{N_T^2} \frac{\sin(2\pi(D2-D1+1)\tau/2N_T)}{\sin(2\pi\tau/2N_T)} \cos(2\pi(D2+D1)/2N_T) \qquad \text{Eq. 49}$$

or using the definition of periodic sine

$$r_x = (\tau) = \frac{2 \cdot \sigma^2 \cdot (D2-D1+1)}{NT_T^2} \cdot Sinc_{D2-D1+1}(2\pi \cdot (D2 - D1 + 1)\tau / 2N_T) \cdot \cos(2\pi(D2 + D1) / 2N_T) \qquad \text{Eq. 50}$$

An efficient derivation of eq. 40 can be obtained, considering the correlation function of the signal just after the modulator (the non-periodic one) function only of $\tau$ parameter (-v<t- ⊙ <$N_T$ and -v<t<$N_T$) .
In conclusion eq. 40 can be rewritten as

$$r_y(\tau,t) = \sum_{u2=-v}^{N_T-1} h^*(t-\tau-u2) \cdot \sum_{u1=-v}^{N_T-1} h(t-u1) \cdot r_x(u1-u2) \qquad \text{Eq. 51}$$

The complexity of this derivation is $(NT+ v)^2$ for each couple t, ⊙ . Eq. 1 cannot be used directly into the computation of correlation matrix due to complexity reason.
It is proposed to define the new function

$$u_x^N(t,u) = \sum_{u1=-v}^{N-1} h(t-u1) \cdot r_x(u1-u) \qquad \text{Eq. 52}$$

By observing that the value of this function into *(t+1,u+1)* is strongly related to the one into *(t+1,u+1)*, it is possible to rewrite eq. 51

$$r_y(\tau,t) = \sum_{u2=-v}^{N_T-1} h^*(t-\tau-u2) \cdot u_x^{N_T}(t,u2) \qquad \text{Eq. 53}$$

Referring to eq. 53 into the (*t+1*) parameter and proving that is strongly related to the value into t and further considering the even symmetry of the $r_x()$ function then it is obtained for the correlation function

$$r_y(\tau,t+1)=r_y(\tau,t)+h^*(t-\tau+v+1)\cdot u_x^{N_T}(t+1,-v)-h^*(t-\tau-N_T+1)\cdot u_x^{N_T}(t,N_T-1)$$

$$+h(t+1+v)\cdot u_x^{N_T}(t-\tau,-v-1)-h(t+1-N_T)\cdot u_x^{N_T}(t-\tau,N_T-1) \qquad \text{Eq. 54}$$

This equation is an iterative solution into the t parameter.

This derivation is very efficient, some of the terms are function of t, other of (*t-* $\tau$). This can help to reduce the complexity because this terms can be derived for all the (*t*, $\tau$) couples.

Other methods to reduce the complexity are related to the hypothesis that it is possible to make on the impulse response (*h(.)*) for example:

    1. Causal: *h* (*n*) =*0* for n<0
    2. Finite length: *h(n)=0* for $n \geq N_h$

Observing that ry(T,t)correlation function is not zero for

    1. *t-* $\tau \geq$-v
    2. *t-* $\tau$-$N_T$+1 $\geq N_h$

this bound can be used to derive the correlation in a more efficient way:

$$r_y(\tau,-v) = h(0) \cdot \sum_{u2=-v}^{N_T-1} h^*(-\tau-u2-v) \cdot r_x(-v-u2) = h(0) \cdot u_x^{N_T}(-v-\tau,-v) \qquad \text{Eq. 55}$$

For what concerns per tone compensation, with full LMS method, there is a different value of energy put for different tones. This is due to PSD shaping of DMT ADSL signal.

A good increment correction have to derive proportionally to the statistical power of input vector. The proposed solution, as mentioned above, is to make this for each per-tone vector.

In other words it has to be derived

$$RF = E[F \cdot T^H \cdot T \cdot F^{-1}] \qquad \text{Eq. 56}$$

and to fix

$$\mu_k = \frac{\mu_0}{RF_{k,k}} \quad k=0,...,N-1 \qquad \text{Eq. 57}$$

Since it is known that DMT signal is a non-stationary signal, so generally eq. 56 is alignment dependent. In this case it is desirable a scaling factor that have to be considered fixed (so not align-dependent). In this case it is considered the mean spectral analysis

$$\bar{r}_{xp}(\tau) = \int_{IC} dt \cdot r_{xp}(\tau,t) \qquad \text{Eq. 58}$$

Being the correlation (not the periodic one) not null for -v[t- 𝟎 <N from eq. 33, 41 and 58 for a DMT signal is obtained

$$\bar{r}_{xp}(\tau) = \left\{ \begin{array}{ll} \left(1 - \dfrac{|\tau|}{N+v}\right) \cdot r_x'(\tau) & |\tau| < N+v \\ \\ 0 & \textit{otherwise} \end{array} \right. \qquad \text{Eq. 59}$$

The mean correlation after the Low Pass Filter of echo-emulation (with h impulse response) path is easily

$$\bar{r}_{yp}(\tau) \int_{IC}^{du} \cdot \bar{r}_{xp}(u) \cdot c_h(\tau-u) \qquad \text{Eq. 60}$$

where

$$c_h(\tau) = \int_u dv \cdot h(v+\tau) \cdot h^*(v) \qquad \text{Eq. 61}$$

A reduced complexity update method can be also used, that will be referred to as "Lambda Even" update. Such a Lambda Even update is described in the European Patent Application No. 02291217.4 in the name of the same Applicant and it was proved in to have good convergence properties, in connection with the full and low modes compensation procedure to improve the performance.

In figure 7 an ADSL transceiver of DMT modem is shown, comprising a transmission branch 100 and a reception branch 200 cross connected by an echo path 400, usually through the hybrid transformer.

On the transmission branch 100 in a block 101 a inverse Fast Fourier trasform operation from N real to N/2 complex is performed on the encoded signal to be transmitted and the CP Cyclic Prefix is added. The signal is then transmitted on the channel via digital to analog conversion in a block 103, preceded by filtration stage 102 comprising a biquadratic filter and shaping filters. Interpolation filters can be used as an alternative. The signal transmitted is defined in ITU-T G.992.1, G992.3, G992.5 standards.

Upstream the block 102 the transmitted signal is taken and sent to an adaptive filter 300. Signal is taken before the filtration stage 102 in order to increase the speed of convergence.

On the reception branch 200 a received signal is passed through an analog to digital converter indicated with 201, passed through a filtration block 202 comprising a biquadratic filter to reach a time domain equalizer 205. Downstream the time domain equalizer 205 is disposed a subtraction node 206 where the output of adaptive filter 300 is subtracted from the received signal to cancel echo. It has to be noted that the DSP front-end is not very important. What is important is that the echo signal is removed before the time domain equalizer 205 to avoid to insert TEQ variation in a adaptive equalization solution.

Subsequently, in a block 207 the Cyclic Prefix is removed and a Fast Fourier trasform operation from N real to N/2 complex is performed, followed by a frequency equalization performed in a block 208.

Finally the received signal reaches a demapper 209 that performs decodification of the symbols. The input and the output of demapper 209 are however taken and subtracted in a subtraction node 210, which output is then feed to a multiplication node 316 of the adaptive filter 300.

It is important to perform a decision of the received symbol even if it is a hard decision. The algorithm implemented in the demapper 209 is very robust and can work even in presence of high probability of wrong decision.

Such an adaptive filter 300 comprises a filtering part 301 and an update part 302. The filtering part 302 comprises a biquadratic filter 303 and a FIR filter 304 with 256 taps.

The signal is taken upstream the FIR filter 304 and sent to the update part 302, firstly to a block 305 performing a Fast Fourier Transform operation from N real to N/2 complex, that yields an even array of values $\downarrow_{even}$ and an odd array of values $\downarrow_{odd}$, that represent the odd and even output of the Fast Fourier Transform on on 2*N samples. As it is based on a decimated transmitted signal, N sample are used. The odd array $\downarrow_{odd}$ undergoes a conjugation operation in a block 306, which result is fed to a multiplication node 313. The even array $\downarrow_{even}$ undergoes a conjugation and hermitian reduction operation in a block 309, which result is fed to a multiplication node 314.

The output of subtraction node 209 is mixed in the multiplication mode 316 with the result of a block 316 that calculates the norm of the output of the frequency equalizer 206. The output of node 316 is fed to a block 307 that performs in association with a block 308 the classical echo cancellation according to a full LMS efficient method.

The output of block 307 is multiplicated in a multiplication node 313 by the output of block 306 and fed to a block 308, that provides for removing the aliasing components in reception inserted by the last decimation stage contained in block 202, by replicating a complex FFT. The result is fed then to a multiplication node 315.

To said multiplication node 315 is also sent the output of a further multiplication node 314, that multiplicates the output of block 309 with output of a block 310 that performs an operation of hermitian extension on the output of node 316.

The output of node 315 is fed to a block 311 in which the calculation of the increment correction, calculating the compensation for the two lower modes, is performed and feed such increment correction to a block 312 where the new update is calculated. The output of block 312 with update is then fed to the FIR filter 304.

In figure 8 it shown an ADSL transceiver implementing the Lambda Even update with low tap compensation.

As it can be seen the lambda odd array evaluation is suppressed.

From the transmitted signal taken upstream the FIR filter 304 only the even array $\lambda_{even}$ is obtained via a folding operation in block 325. Then a real Fast Fourier trasform operation is performed in block 326. Then he even array undergoes a conjugation and hermitian reduction operation in the block 309, which result is fed to a multiplication node 314.

The output of subtraction node 209 is mixed in the multiplication mode 316 with the result of a block 317 that calculates the norm of the output of the frequency equalizer 206.

The output of node 314 is then fed to the block 311 in which the calculation of the increment correction is performed and feed such increment correction to a block 312 where the new update is calculated. The output of block 312 with update is then feed to the FIR filter 304.

The proposed method, by introducing low modes compensation increases the performances of the echo canceller adaptive method.

The proposed method advantageously obtains a speed of convergence that is approximately the same for different alignments. Further, the efficiency of the adaptive method is increased, as can be seen comparing the mean quantitative of excess noise cancelled per update normalised by the computational complexity of each update. It was shown that this method can be ten times more efficient during tracking than all other methods known from the prior art.

The advantage in efficiency so obtained can be traded both to reduce the computational complexity, thus obtaining a reduced digital area for a hardware implementation or a less complex Digital Signal Processing unit in a software implementation, or to increase the number of update in the same time unit.

Without prejudice to the underlying principle of the invention, the details and embodiment may vary, also significantly with respect to what has been discussed just by way of example without departing from the scope of the invention, ad defined by the claims that follow.

For instance the solution described herein can be applied to all ADSL modem, in Central Office or Customer Premises' Equipment.

**Claims**

**1.** A method for cancelling the Echo part of a received DMT signal in presence of a Far-End signal in ADSL modem, that includes the step of

performing an adaptive filtration of the signal by means of a digital filter (304) having multiple taps, the adaptation of the filter being implemented through full Least Mean Square error procedure,

said Least Mean Square procedure comprising the step of estimating the impulse response ($w(k)$) of said digital filter (304), evaluating an update ($w(k+1)$) of the estimation ($w(k)$) in function of a correction increment parameter($\mu_k$)

**characterized in that** further includes the steps of:

performing a per-tone compensation step that comprises evaluation of a per-tone increment correction ($\mu_k$) that depends on the mask of tones ($R_T$) used.

**2.** The method of claim 1 **characterized in that** further comprises the step of

evaluating a per-tone optimal increment correction matrix ($\mu_{f,PT}$) and

performing a low taps compensation reducing the number of modes to be compensated in the update ($w(k+1)$) to a subset ($N_{LM}$) limited to the lower modes, adding to the per-tone optimal increment correction matrix ($\mu_{f,PT}$) one or more compensation terms to obtain the convergence, in order to have a high efficiency in terms of computational complexity.

**3.** The method of claim 2 **characterized in that** the added compensation terms are two, corresponding to the two lower modes of said subset ($N_{Lm}$) .

**4.** The method of any of the preceding claims

**characterized in that** the real per-tone compensation is performed into frequency domain.

**5.** The method of any of the preceding claims **characterized in that** said low taps compensation procedure is performed into frequency domain.

**6.** The method of any of the preceding claims **characterized in that** said low taps compensation is performed into the time domain.

**7.** The method of any of the preceding claims **characterized in that** said low taps compensation is align-dependent.

**8.** The method of any of the preceding claims **characterized in that** the compensation vector can be obtained with a circulant shift of an original vector, so that it is not needed to access to a compensation vector for each align.

**9.** The method of any of the preceding claims **characterized in that** comprises the step of evaluating the mask of tone used in the per-tone compensation step imposing:

- uncorrelation of samples of different symbols;
- uncorrelation between real and imaginary information per-tone ;
- uncorrelation between information on different tones;
- that the statistical power for real and imaginary part is the same for each tone.

**11.** The method of any of the preceding claims **characterized by** the step of evaluating the mask of tone used in the per-tone compensation step imposing that all used tones have the same power.

**12.** The method of any of the preceding claims **characterized in that** the per-tone compensation step comprises evaluation of a per-tone increment correction ($\mu_k$) by deriving each per-tone vector proportionally to the statistical power of input vector (*T*).

**13.** The method of any of the preceding claims **characterized in that** the update (w(k+1) is calculated using a Lambda even update procedure that provides for calculating a subarray ($\lambda_{even}$) of the eigenvalues of the correlation matrix.

**14.** A DMT modem apparatus comprising an adaptive filter (304) performing the steps of the method of any of the claims 1 to 9.

**15.** The apparatus of claim 9 **characterized in that** is a Central Office modem.

**16.** A computer program product directly loadable in the memory of a digital computer and comprising software code portions for performing the method of any of the claims 1 to 9 when the product is run on a computer.

Fig. 1A

Fig. 1B

EP 1 501 191 A1

Fig. 2B

Legend:
- --- Far End
- • Far End
- — Residual Echo
- -- Noise
- -.- ICI-ISI Far-End Signal
- -*- Received Echo

tones

Fig. 2A

Legend:
- — Tones 0-32
- --- Tones 33-59
- --- Tones 60-64

simbols

Fig.3A

Fig.3B

Fig. 4A

Fig. 4B

EP 1 501 191 A1

Fig. 5A

Fig. 5B

Fig. 6A

Fig. 6B

EP 1 501 191 A1

Fig_7

EP 1 501 191 A1

Fig.8

EP 1 501 191 A1

**European Patent Office**

**EUROPEAN SEARCH REPORT**

Application Number

EP 03 01 6993

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | SHYNK J J: "FREQUENCY-DOMAIN AND MULTIRATE ADAPTIVE FILTERING" IEEE SIGNAL PROCESSING MAGAZINE, IEEE INC. NEW YORK, US, vol. 9, no. 1, 1992, pages 14-37, XP000436314 ISSN: 1053-5888 * page 18, left-hand column, line 23 - right-hand column, line 28 * * page 23, left-hand column, line 22 - line 29 * --- | 1-5, 14-16 | H03H21/00 H04B3/23 H04L27/26 |
| X | GAY S L: "A fast converging, low complexity adaptive filtering algorithm" APPLICATIONS OF SIGNAL PROCESSING TO AUDIO AND ACOUSTICS, 1993. FINAL PROGRAM AND PAPER SUMMARIES., 1993 IEEE WORKSHOP ON NEW PALTZ, NY, USA 17-20 OCT. 1993, NEW YORK, NY, USA,IEEE, 17 October 1993 (1993-10-17), pages 4-7, XP010130092 ISBN: 0-7803-2078-6 * page 4, right-hand column, line 6 - line 14 * * page 5, left-hand column, line 28 - line 33 * * page 6, right-hand column, line 14 - line 20 * ----- | 1,6, 14-16 | TECHNICAL FIELDS SEARCHED (Int.Cl.7) H04B H04L H03H H04M |

The present search report has been drawn up for all claims

| Place of search | Date of completion of the search | Examiner |
|---|---|---|
| MUNICH | 3 November 2003 | Täger, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)